# EUROPEAN PATENT APPLICATION

(11) **EP 3 343 480 A1**
(43) Date of publication of application: **04.07.2018**
(21) Application number: 17209807.1
(22) Date of filing: 21.12.2017
(51) Int. Cl.: G06Q 10/06, G06Q 50/04, G05B 23/02

(54) **SYSTEMS AND METHODS FOR IMPROVING ELECTRONIC COMPONENT QUALITY DURING THE MANUFACTURE OF VEHICLES**

(30) Priority: 30.12.2016 US 201615395781
(71) Applicant: Paccar Inc, Bellevue, WA 98004 (US)
(72) Inventor: Briggs, Ricky-Dale Lewis, Monroe, WA 98272 (US)
(74) Representative: Calysta NV

(57) **Abstract**

Embodiments of the present disclosure are directed to improving the quality of electronic components suitable for use in vehicles such as Class 8 trucks. Vehicles such as Class 8 trucks are becoming more complex and using more electronic components, and so the likelihood of proper functionality and successful integration of such components must be ensured before being incorporated into a manufactured vehicle. Embodiments of the present disclosure ensure that suppliers can successfully manufacture the electronic components, and that the quality of the electronic components remains high for successful integration into the vehicle during manufacture.

## Description

### BACKGROUND

The design and manufacture of vehicles, including but not limited to Class 8 trucks, is becoming increasingly complex. The increasing number of parts, coming from an increasing number of suppliers, leads to difficulties in ensuring consistent quality for each separate part and supplier. This is particularly true for electronic components, where logic may be created by a first supplier while the electronic component itself is created by a second supplier, and both are integrated with the vehicle by a separate manufacturer. What is needed is a way for a manufacturer of a vehicle to be able to ensure and increase the quality of electronic components in order to reduce later defects found in operating vehicles.

### SUMMARY

This summary is provided to introduce a selection of concepts in a simplified form that are further described below in the Detailed Description. This summary is not intended to identify key features of the claimed subject matter, nor is it intended to be used as an aid in determining the scope of the claimed subject matter.

In some embodiments, a vehicle is provided. The vehicle comprises one or more electronically controlled components and at least one electronic control unit (ECU). The ECU is configured to control an action of at least one of the one or more electronically controlled components. The ECU is configured and installed in the vehicle by selecting a supplier based on a need of a manufacturing process of the ECU, receiving data from the supplier during a design process and using the data to monitor the supplier, testing a completed ECU provided by the supplier, and installing the tested ECU in the vehicle.

In some embodiments, a method of manufacturing a vehicle that includes an electronic component is provided. A supplier is selected based on a need of a manufacturing process of the electronic component. Data is received from the supplier during a design process and the data is used to monitor the supplier. A completed electronic component provided by the supplier is tested, and the tested electronic component is installed in the vehicle.

In some embodiments, a computing system for improving the quality of production of an electronic component for a vehicle is provided. The system comprises a supplier interface module, a supplier intake questionnaire data store, a supplier compliance data store, and a test data store. The supplier intake questionnaire data store is configured to store responses from suppliers received by the supplier interface module. The supplier compliance data store is configured to store data received by the supplier interface module from suppliers during a design process of the electronic component. The test data store is configured to store test data for the electronic component.

### DESCRIPTION OF THE DRAWINGS

The foregoing aspects and many of the attendant advantages of this invention will become more readily appreciated as the same become better understood by reference to the following detailed description, when taken in conjunction with the accompanying drawings, wherein:
FIGURE 1 is a schematic diagram that illustrates an example embodiment of a vehicle in which electronic components are employed according to various aspects of the present disclosure;
FIGURE 2 is a block diagram that illustrates an example embodiment of a quality improvement system according to various aspects of the present disclosure;
FIGURES 3A-3B are a flowchart that illustrates an example embodiment of a method of improving quality during vehicle manufacturing according to various aspects of the present disclosure;
FIGURES 4A-4F are charts that illustrate example metrics useful for improving quality during vehicle manufacturing according to various aspects of the present disclosure; and
FIGURE 5 is a block diagram that illustrates aspects of an example computing device 500 appropriate for use as a computing device of the present disclosure.

### DETAILED DESCRIPTION

Embodiments of the present invention will now be described with reference to the drawings where like numerals correspond to like elements. Embodiments of the present disclosure are generally directed to improving the quality of electronic components suitable for use in vehicles, such as Class 8 trucks. Although exemplary embodiments of the present disclosure will be described hereinafter with reference to Class 8 trucks, it will be appreciated that aspects of the present disclosure have wide application, and therefore, may be suitable for use with many types of electrically powered, mechanically powered or hybrid powered vehicles that include electronic components, such as passenger vehicles, buses, commercial vehicles, etc. Accordingly, the following descriptions and illustrations herein should be considered illustrative in nature, and thus, not limiting the scope of the claimed subject matter.

In the following description, numerous specific details are set forth in order to provide a thorough understanding of exemplary embodiments of the present disclosure. It will be apparent to one skilled in the art, however, that many embodiments of the present disclosure may be practiced without some or all of the specific details. In some instances, well-known process steps have not been described in detail in order not to unnecessarily obscure various aspects of the present disclosure.

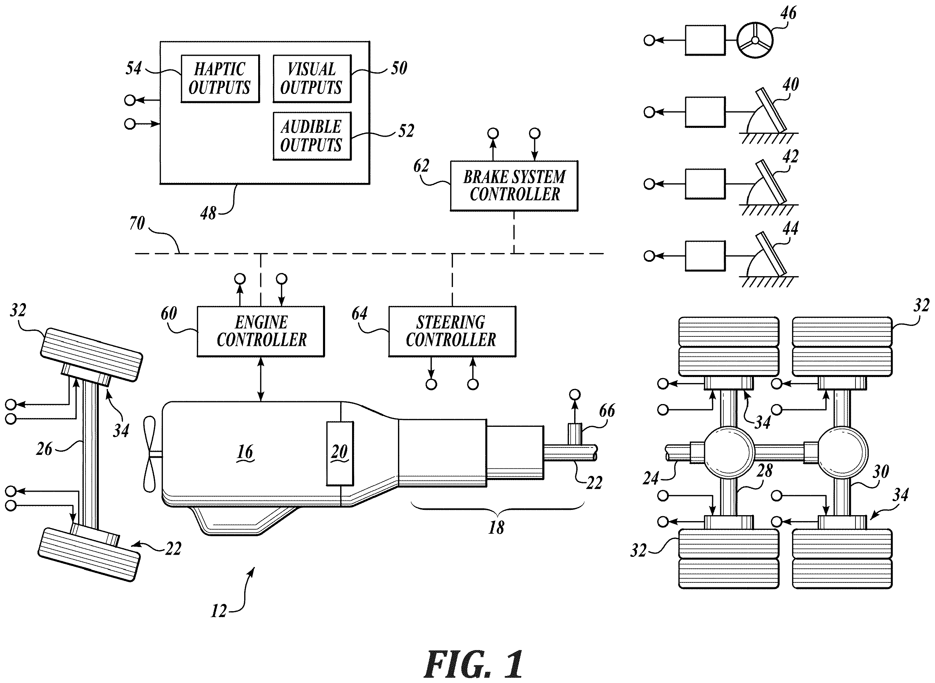

As briefly described above, embodiments of the present disclosure are directed to systems and methods for improving the quality of electronic components suitable for use in a vehicle. One typical vehicle in which such electronic components may be employed will now be described in more detail with reference to FIGURE 1. As best shown in FIGURE 1, a Class 8 tractor 12 of a tractor-trailer combination 10 (hereinafter "vehicle 10" or "combination 10"), having an electronically controlled engine 16 coupled to a transmission 18 via a clutch mechanism 20 is shown. Although a vehicle such as depicted in FIGURE 1 represents one of the possible applications for the systems and methods of the present disclosure, it should be appreciated that aspects of the present disclosure transcend any particular type of vehicle or electronic component.

In the embodiment shown in FIGURE 1, the transmission 18 may be an automated manual transmission or an automatic transmission that includes an output shaft 22 coupled to a vehicle drive shaft 24. The tractor 12 includes at least two axles such as a steer axle 26 and at least one drive axle, such as axles 28 and 30. Each axle supports corresponding wheels 32 having service brake components 34. The service brake components 34 may include electronic components such as wheel speed sensors, electronically controlled pressure valves, and the like, to effect control of the vehicle braking system.

The tractor 12 may also include conventional operator control inputs, such as an accelerator pedal 40, a service brake pedal 42, a parking brake 44, and a steering wheel 46 to effect turning of the front wheels of the vehicle 20. The tractor 12 may further include a cab mounted operator interface, which may include any of a number of electronic components including but not limited to output devices 48, such as visual output devices 50 (including but not limited to lights, displays, and gauges), audible output devices 52 (including but not limited to speakers and headphones) and haptic feedback devices 54. The output device 48 may be stand alone, integrated with the instrument panel, with a rear view mirror or a side view mirror, mounted in, on or over a hood of the vehicle, and/or located and/or integrated with any other suitable structure in the vehicle. The cab mounted operator interface may also include electronic components associated with various input devices (not shown), such as toggle switches, push button switches, potentiometers, or the like.

The tractor 12 is further equipped with a vehicle control system that includes electronic components such as one or more electronic control units (ECUs) for controlling several systems and subsystems of the vehicle. The vehicle control system may include a controller associated with the engine 16 ("engine controller 60"). Generally described, the engine controller 60 is an electronic component that functions to manage various aspects of the operation of the engine 16. For example, the engine's ignition timing, fuel consumption, and the like, may be monitored and controlled by the engine controller 60. The vehicle control system may include other controllers for controlling other vehicle systems. For example, the vehicle control system may include a transmission controller (not shown) for controlling transmission shifting, a brake system controller 62 for controlling the operation of the service brake components 34, and a steering controller 64 for controlling the turning of the wheels 32 of the steer axle 26.

To support this control, the various electronic components may communicate with each other through a vehicle-wide communications network. Those skilled in the art and others will recognize that the vehicle-wide communications network may be implemented using any number of different communication protocols such as, but not limited to, Society of Automotive Engineers' ("SAE") J1587, SAE J1922, SAE J1939, SAE J1708, and combinations thereof. Alternatively, the aforementioned controllers may be software control modules contained within an electronic component such as a general purpose controller or ECU residing on the vehicle. It will be appreciated, however, that the present disclosure is not limited to any particular type or configuration of controller, or to any specific control logic for governing operation of vehicle 10.

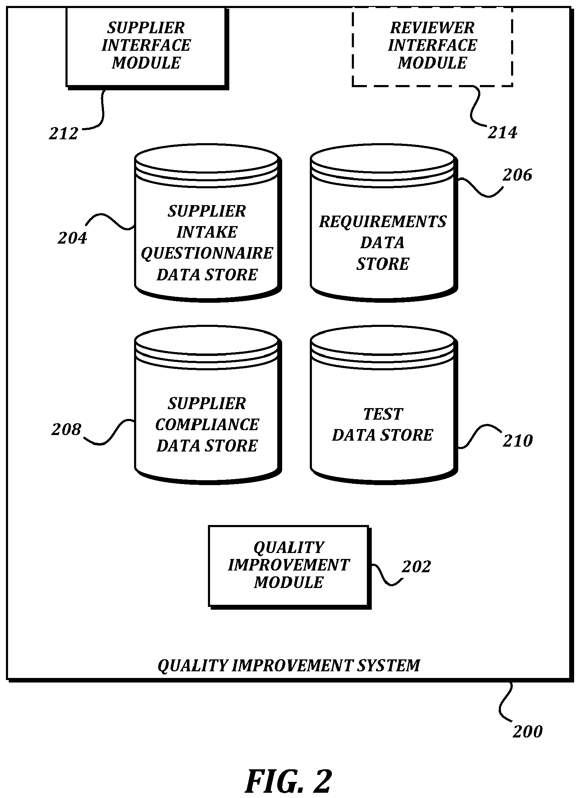

FIGURE 2 is a block diagram that illustrates an example embodiment of a quality improvement system according to various aspects of the present disclosure. As illustrated, the quality improvement system 200 includes a quality improvement module 202, a supplier interface module 212, and a reviewer interface module 214.

In general, the term "module" as used herein refers to logic embodied in hardware such as an engine control unit (ECU), an application-specific integrated circuit (ASIC) or a field-programmable gate array (FPGA); or embodied in software instructions executable by a processor of an ECU, an ASIC, an FPGA, or a computing device as described below. The logic can be written in a programming language, such as C, C++, COBOL, JAVA™, PHP, Perl, HTML, CSS, JavaScript, VBScript, ASPX, HDL, Microsoft .NET™ languages such as C#, and/or the like. A module may be compiled into executable programs or written in interpreted programming languages. Modules may be callable from other modules or from themselves. Generally, the modules described herein refer to logical components that can be merged with other modules, or can be divided into sub-modules. The modules can be stored in any type of computer readable medium or computer storage device and be stored on and executed by one or more general purpose computers, thus creating a special purpose computer configured to provide the module. Accordingly, the devices and systems illustrated herein may include one or more computing devices configured to provide the illustrated modules, though the computing devices themselves have not been illustrated in every case for the sake of clarity.

The supplier interface module 212 is configured to receive information provided by suppliers. In some embodiments, the information provided by suppliers may be usable to evaluate the capabilities of the suppliers for future projects. In some embodiments, the information provided by suppliers may be usable to monitor progress of the creation/development of components during the design and implementation process. In some embodiments, the supplier interface module 212 may generate a user interface such as a web interface and/or the like through which the information may be submitted by the suppliers. In some embodiments, the supplier interface module 212 may provide one or more application programming interfaces (APIs) through which information may be programmatically submitted by suppliers. In some embodiments, the supplier interface module 212 may support one or more electronic data interchange (EDI) formats by which information may be submitted by suppliers.

The reviewer interface module 214 is configured to receive information provided by suppliers. In some embodiments, reviewers may review information provided by suppliers and provide additional ratings of the suppliers based on that information. In some embodiments, reviewers may interview the suppliers and provide the answers to the interview questions via the reviewer interface module 214, instead of the suppliers providing the answers directly to the supplier interface module 212. In some embodiments, the reviewer interface module 214 may provide one or more APIs through which reviewers may provide information, while in some embodiments, the reviewer interface module 214 may instead provide a web-based user interface or an EDI interface by which information may be submitted. The reviewer interface module 214 is illustrated as being optional because, in some embodiments, the activities performed by a reviewer may instead be performed automatically by other components of the quality improvement system 200.

The quality improvement module 202 is configured to manage the other components of the quality improvement system 200, and to thereby improve and ensure the quality of electronic components incorporated into the vehicle 10. The quality improvement module 202 may analyze data collected by the supplier interface module 212 and/or the reviewer interface module 214 in order to automatically select or recommend suppliers and to monitor the quality of electronic components produced by suppliers. In some embodiments, the quality improvement module 202 may also monitor the quality of electronic components by receiving information from components operating in vehicles 10 in the field, and may generate alerts or other information when patterns of reduced quality emerge.

The quality improvement system 200 also includes a supplier intake questionnaire data store 204, a requirements data store 206, a supplier compliance data store 208, and a test data store 210. As understood by one of ordinary skill in the art, a "data store" as described herein may be any suitable device configured to store data for access by a computing device. One example of a data store is a highly reliable, high-speed relational database management system (DBMS) executing on one or more computing devices and accessible over a high-speed packet switched network. However, any other suitable storage technique and/or device capable of quickly and reliably providing the stored data in response to queries may be used, including but not limited to a key-value store and a NoSQL database. Further, the computing device may be accessible locally instead of over a network, or may be accessible over some other type of suitable network or provided as a cloud-based service. A data store may also include data stored in an organized manner on a storage medium 508, as described further below. The organized manner may include, but is not limited to, files within a file system and one or more spreadsheets. One of ordinary skill in the art will recognize that separate data stores described herein may be combined into a single data store, and/or a single data store described herein may be separated into multiple data stores, without departing from the scope of the present disclosure.

The supplier intake questionnaire data store 204 is configured to store information from suppliers, including information provided in response to questions intended to determine the suppliers' capabilities for designing and/or manufacturing electronic components. The requirements data store 206 is configured to store information that defines at least one of user requirements, functional requirements, system requirements, and performance requirements for electronic components to be included in the vehicle 10 being designed. In some embodiments, a requirement may specify functionality for the vehicle 10, and various components may be designed in order to fulfil the requirement.

A user requirement, sometimes known as a use case, may be a feature or function that the vehicle operator, fleet operator, or vehicle owner is able to experience directly in the normal operation of the vehicle. A non-limiting example of a user requirement may be that a progressive shift indicator should be displayed based on a given engine speed and gear ratio. A functional requirement may be a feature or function determined for the correct operation of the vehicle 10 and may span the full range of vehicle behavior. A non-limiting example of a functional requirement may be a fuel-air mixture setting provided to a fuel injection system based on data generated by various sensors. A system requirement may include integration requirements that include interactions, collection of data, and passing of data from input/output devices and other electronic components within the vehicle 10. System requirements may specify one or more of data size, repetition rate, formatting, proper usage of J1939 communications, and analog or digital inputs and outputs. Performance requirements may specify one or more factors including, but not limited to, an expected duty cycle, an expected operating environment (including but not limited to temperature ranges, altitudes, and amounts of moisture expected), a throughput, a responsiveness, or a data rate.

The supplier compliance data store 208 is configured to store information provided by suppliers during design of electronic components. In some embodiments, the information from the supplier compliance data store 208 may include information from which metrics may be created in order to analyze and compare the quality of the development processes being used by the suppliers. In some embodiments, the supplier compliance data store 208 may also be configured to store information regarding testing (or derived from testing information).

The test data store 210 is configured to store information relating testing. In some embodiments, the information may include records that describe test cases to be executed, either manually by a technician or by an automated test framework or fixture. In some embodiments, the test information may include data to be provided to an electronic component, and may also include expected outputs from the electronic component. In some embodiments, the test data store 210 may also be configured to store the results of test execution.

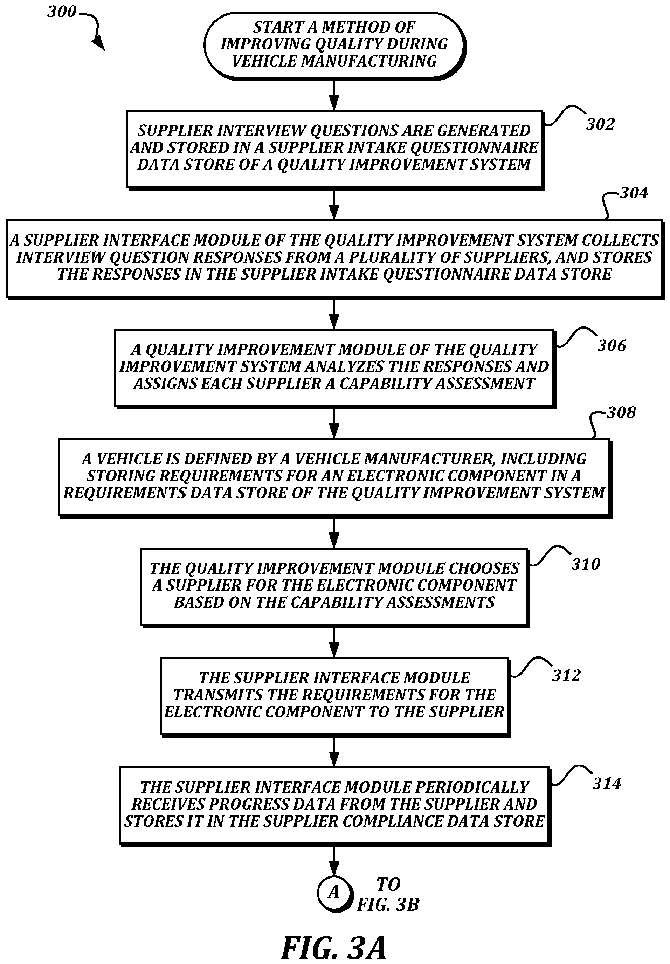

FIGURES 3A-3B are a flowchart that illustrates an example embodiment of a method of improving quality during vehicle manufacturing according to various aspects of the present disclosure. From a start block, the method 300 proceeds to block 302, where supplier interview questions are generated and stored in a supplier intake questionnaire data store 204 of a quality improvement system 200. In some embodiments, 150 questions or more may be created in order to probe various aspects of supplier capabilities, including but not limited to a number of developers on staff, a yearly revenue amount, a number of other concurrent projects, and so on. In some embodiments, the questions may be designed to identify whether a supplier has a minimal capability to develop electronic components (including software and/or hardware), and to follow development and quality assurance processes established by the provider of the quality improvement system 200.

Next, at block 304, a supplier interface module 212 of the quality improvement system 200 collects interview question responses from a plurality of suppliers, and stores the responses in the supplier intake questionnaire data store 204. In some embodiments, suppliers would connect to an interface provided by the supplier interface module 212 in order to receive and answer the questions, possibly as a part of a request for proposal (RFP) process initiated by the vehicle manufacturer or other provider of the quality improvement system 200. In some embodiments, a reviewer may ask the supplier for responses to the interview questions, and the reviewer may submit the response to the quality improvement system 200. In some embodiments, a reviewer may compile information from publicly available information sources and enter such information as question responses. In some embodiments, other techniques may be used to collect the interview question responses for storage in the supplier intake questionnaire data store 204.

Next, at block 306, a quality improvement module 202 of the quality improvement system 200 analyzes the responses and assigns each supplier a capability assessment. In some embodiments, a capability assessment such as ISO/IEC 15504, also known as Automotive Software Process Improvement and Capability Determination (A-SPICE), or a substantially similar assessment, may be used. Such an assessment can determine the capability of the supplier's development process in order to appropriately assess risk, mitigate gaps, or require updates before starting a program. In some embodiments, a result of a past assessment may be reused for a new project. For example, if a new project includes changes to less than 5% of the requirements of an existing project, an existing assessment may be reused. Also, if a new project includes between 5% and 30% in requirement changes, an existing capability assessment may be used as long as it had been conducted within the last 3 years. Other projects should conduct new capability assessments before selecting a supplier.

The capability assessment may be performed by a reviewer via an interface provided by the reviewer interface module 214, and may be based on the questionnaire answers stored in the supplier intake questionnaire data store 204, or based on a combination of such answers as well as additional research conducted by the reviewer to complete the assessment. The result of the assessment may be a numerical capability score, such as an ASPICE capability level, and the result may be stored in the supplier intake questionnaire data store 204 as an additional piece of data about the supplier.

At block 308, a vehicle is defined by a vehicle manufacturer, including storing requirements for an electronic component in a requirements data store 206 of the quality improvement system 200. Requirements may be used to measure a size of a given design/development project, and so requirements may be stored in the requirements data store 206 organized or labeled according to which sub-contractable component the requirements belong to. The following discussion will describe requirements relating to a single electronic component that can be designed and provided by a single supplier for ease of discussion, but one of ordinary skill in the art will recognize that the techniques may be performed to concurrently assess, select, and monitor multiple suppliers for multiple electronic components for a vehicle 10.

At block 310, the quality improvement module 202 chooses a supplier for the electronic component based on the capability assessments. In some embodiments, the selection of a supplier for a given project may depend on the scope of a project. For example, critical systems such as an engine controller or a brake system may suggest that a supplier with an A-SPICE capability assessment of at least 3 should be chosen. Other systems that are important but not critical to safety, such as a transmission controller, instrumentation, or a chassis controller, may suggest that a supplier with an A-SPICE capability assessment of at least 2 should be chosen. Other components, such as displays, radios, door controls, telematics, interior lighting, or an HVAC controller, may suggest that a supplier with an A-SPICE capability assessment of at least 1 should be chosen. In some embodiments, the requirements stored in the requirements data store 206 could include a level of capability assessment that is desired for the component, and so the selection of a supplier could be done automatically by the quality improvement module 202. In some embodiments, the quality improvement module 202 could choose the supplier while guided by input via the reviewer interface module 214. In some embodiments, the quality improvement module 202 could automatically cause a list of suppliers and capability assessments which meet criteria associated with the requirements to be presented to a reviewer, and a selection by the reviewer could be made from that list.

Next, at block 312, the supplier interface module 212 transmits the requirements for the electronic component to the supplier. The requirements may be transmitted using any suitable technique, including but not limited to email, SMS, a formal letter, and an electronic data interchange (EDI). Details regarding the transmission including but not limited to the technique, the requirements transmitted, and the date and/or time of transmission may be recorded in the supplier compliance data store 208.

At block 314, the supplier interface module 212 periodically receives progress data from the supplier and stores it in the supplier compliance data store 208. Some examples of progress data may include, but are not limited to, lines of code, requirements completed, and defect count. Further examples of progress data are described below. The progress data may be transmitted to the supplier interface module 212 using any suitable technique, including but not limited to email, SMS, EDI, or entry into a user interface provided by the supplier interface module 212. In some embodiments, the supplier may provide the progress data on a periodic basis during the development process, such as daily, weekly, bi-weekly, monthly, and/or the like. In some embodiments, the supplier interface module 212 may have direct access to systems of the supplier, and may pull the desired information from the supplier systems on-demand. In some embodiments, the supplier may use the supplier interface module 212 to track their own progress (e.g., the supplier interface module 212 may provide source code control, test case tracking, and/or the like), and so may update the progress data in real time as progress is made.

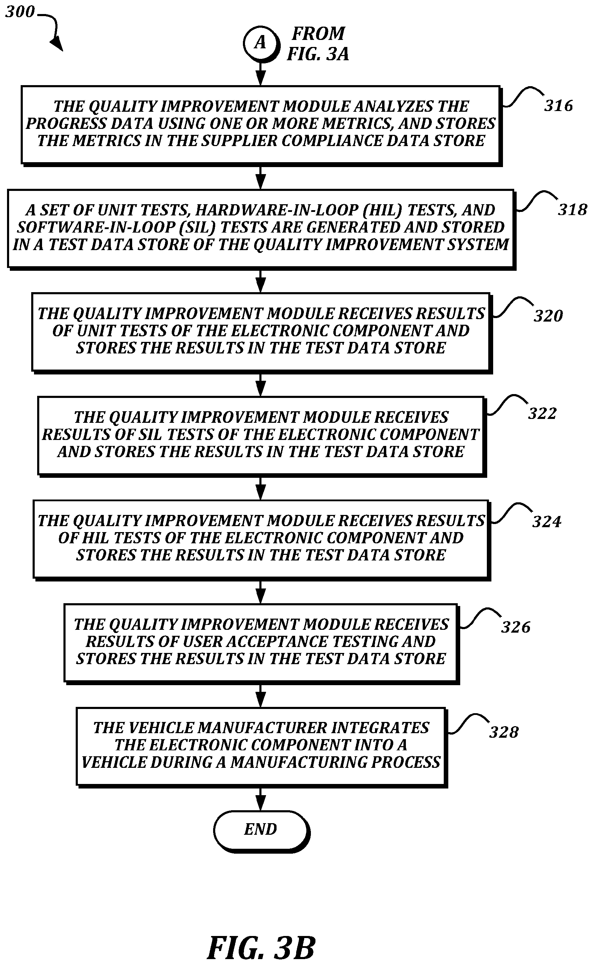

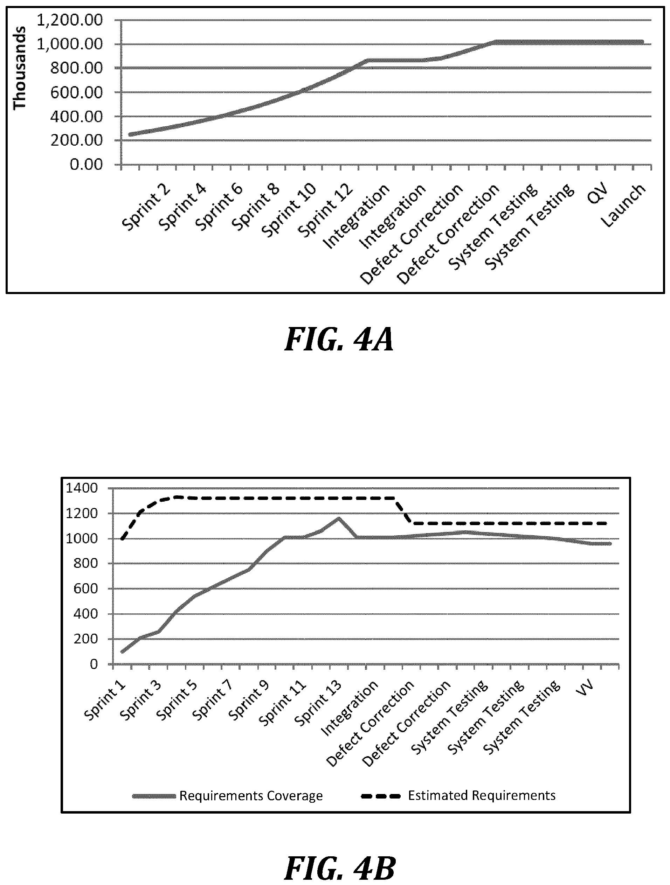

The method 300 then proceeds to a continuation terminal ("terminal A"), and from terminal A (FIGURE 3B) to block 316, where the quality improvement module 202 analyzes the progress data using one or more metrics, and stores the metrics in the supplier compliance data store 208. In some embodiments, the quality improvement module 202 may calculate the metrics each time progress data is added to the supplier compliance data store 208. In some embodiments, the quality improvement module 202 may calculate the metrics periodically, but on a different schedule than the progress data transmission schedule. In some embodiments, the quality improvement module 202 may calculate the metrics on demand when a metric evaluation is desired. In some embodiments, the metrics may be used by the quality improvement system 200 to determine whether a supplier is performing poorly enough to be changed during a project, or may be used by the quality improvement system 200 to determine whether a supplier will be suitable for future projects. FIGURES 4A-4F, which are described further below, illustrate some example metrics that may be used by some embodiments of the present disclosure.

The method 300 then proceeds to block 318, where a set of unit tests, hardware-in-loop (HIL) tests, and software-in-loop (SIL) tests are generated and stored in a test data store 210 of the quality improvement system 200. In some embodiments, unit tests may include the independent test of software and/or hardware aspects of electronic components in a simulated environment prior to integration into an executable software version. Each of the unit tests may be documented and traceable to requirements stored in the requirements data store 206. HIL tests and SIL tests may be functional tests that ensure that the functionality of the complete electronic component has been properly implemented. SIL tests may include the complete electronic component being tested in a test fixture that simulates the inputs from the rest of the vehicle 10 and monitors the outputs generated by the electronic component. HIL tests may include the complete electronic component being tested in a test fixture that includes hardware components of the vehicle 10 instead of simulated inputs to the electronic component.

The tests stored in the test data store 210 may include edge cases to ensure that particular or unexpected data or operating conditions do not cause the electronic component to fail. The tests may also include performance test cases including but not limited to cases for testing data throughput, processing volume, memory usage, or power usage. The tests may be executable automatically or manually, and may include both a definition of a test to be performed and an acceptable result. In some embodiments, the tests stored in the test data store 210 may be documented in a commercially available test and tracking tool and traceable to requirements stored in the requirements data store 206. Some tests may be transmitted to the supplier to be executed, while other tests may be executed by the vehicle manufacturer on prototype electronic components provided by the supplier (or on other electronic components). Some tests may be conducted by customers/operators of the vehicle 10 once the entire vehicle 10 is assembled.

At block 320, the quality improvement module 202 receives results of unit tests of the electronic component and stores the results in the test data store 210. Next, at block 322, the quality improvement module 202 receives results of SIL tests of the electronic component and stores the results in the test data store 210. At block 324, the quality improvement module 202 receives results of HIL tests of the electronic component and stores the results in the test data store 210. In some embodiments, any of blocks 320-324 may be repeated until satisfactory test results are obtained until moving on to the next block. In some embodiments, some of the test results may be provided by the supplier via the supplier interface module 212. In some embodiments, some of the tests may be conducted by the vehicle manufacturer, and the results may be provided to the supplier for generating fixes. In some embodiments, a test fixture may be configured to automatically retrieve the test information from the test data store 210, automatically execute the tests, and automatically report the test results back to the quality improvement module 202.

Next, at block 326, the quality improvement module receives results of user acceptance testing and stores the results in the test data store 210. In some embodiments, user acceptance testing includes the results of tests executed by users and reported back to the quality improvement system 200. In some embodiments, user acceptance testing may include problems reported by users that do not coincide directly with any tests, and the reports of such problems may be used to generate new requirements or test cases. In some embodiments, user acceptance testing may include automatically collecting test result data collected by one or more sensors on a vehicle 10 in the field. The test result data may be collected and transmitted to the quality improvement system 200 via any suitable technique, including but not limited to wireless communication directly from the vehicle 10 to the quality improvement system 200, by downloading the data from the vehicle 10 by a diagnostic device communicatively coupled to the vehicle and transmitting the data from the diagnostic device to the quality improvement system 200, or by any other suitable technique.

At this point in the method 200, testing is complete, and so the electronic component is in its fully tested form. Accordingly, at block 328, the vehicle manufacturer integrates the electronic component into a vehicle during a manufacturing process. In some embodiments, this may include the vehicle manufacturer receiving programmed electronic components from supplier to be installed in the vehicle 10 during manufacturing. In some embodiments, this may include the vehicle manufacturer receiving hardware and/or software to be installed in the electronic component in order to provide the electronic component with functionality designed by the supplier. In some embodiments, the actual electronic component that was tested is installed in the vehicle. In some embodiments, a sample electronic component is tested, while another electronic component that was designed and manufactured using the same process as the sample electronic component is installed in the vehicle.

The method 300 then proceeds to an end block and terminates.

FIGURES 4A-4F are charts that illustrate example metrics useful for improving quality during vehicle manufacturing according to various aspects of the present disclosure. FIGURE 4A is a chart that illustrates a code growth metric useful according to various aspects of the present disclosure. Code growth analyses the progress over time in the number of lines of code generated during the development cycle. For a healthy development process, a normal distribution of code growth may be expected over each interval sprint. The code growth may then taper off towards the end of development as defect correction and cleanup activities become a larger part of the development process. Accelerating code growth at the end of a program or during system integration may indicate a risk to electronic component quality. In some embodiments, code growth for software projects may be normalized by counting lines of C code (or code in another programming language) that are generated. For projects in which a model-based software tool is used, the models may be compiled into C code to generate the count of lines of code. In some embodiments, lines of code may be reported in thousands (or other round units).

FIGURE 4B is a chart that illustrates a requirements coverage metric useful according to various aspects of the present disclosure. At the beginning of a program, an estimation of the number of requirements may be generated based on the number of use cases or functional requirements. As shown in the chart, requirements coverage measures the progress over time in completing those requirements. As the program progresses, re-estimation of the total requirements may occur.

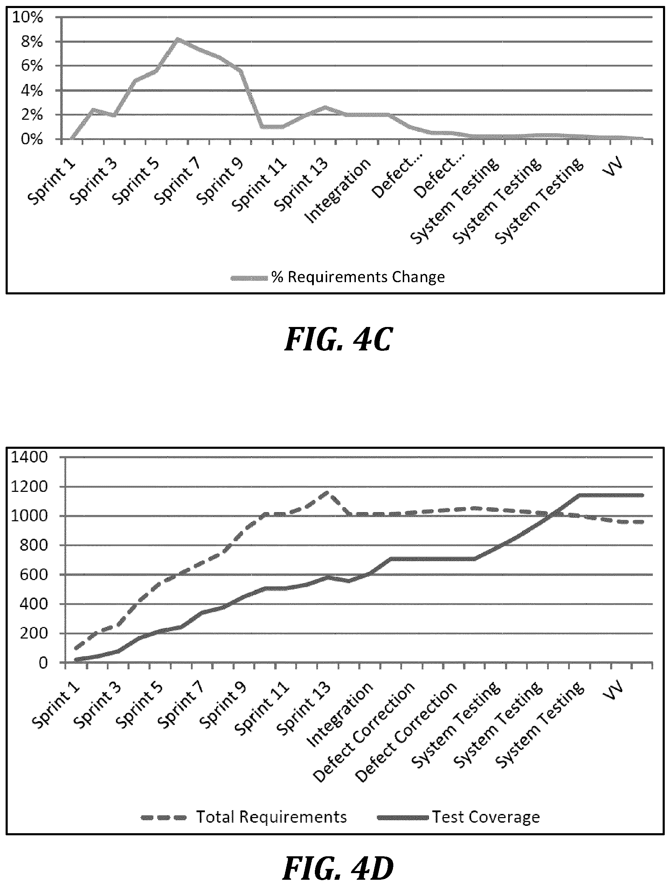

FIGURE 4C is a chart that illustrates a requirements change management metric useful according to various aspects of the present disclosure. This metric monitors a version change in existing requirements, and verifies that the expected development and revision process for requirements is being conducted and completed prior to integration testing. One example calculation of a percentage requirements change is calculated by dividing a total number of changes in an interval (such as a week) by the total number of active requirements.

FIGURE 4D is a chart that illustrates a test coverage metric useful according to various aspects of the present disclosure. In some embodiments, each requirement stored in the requirement data store 206 should be associated with at least one test case in the test data store 210. The test coverage metric tracks the test plan from unit testing through integration testing and finally system and user acceptance testing. One purpose of this metric is to verify that all requirements are validated during the appropriate point in the development cycle.

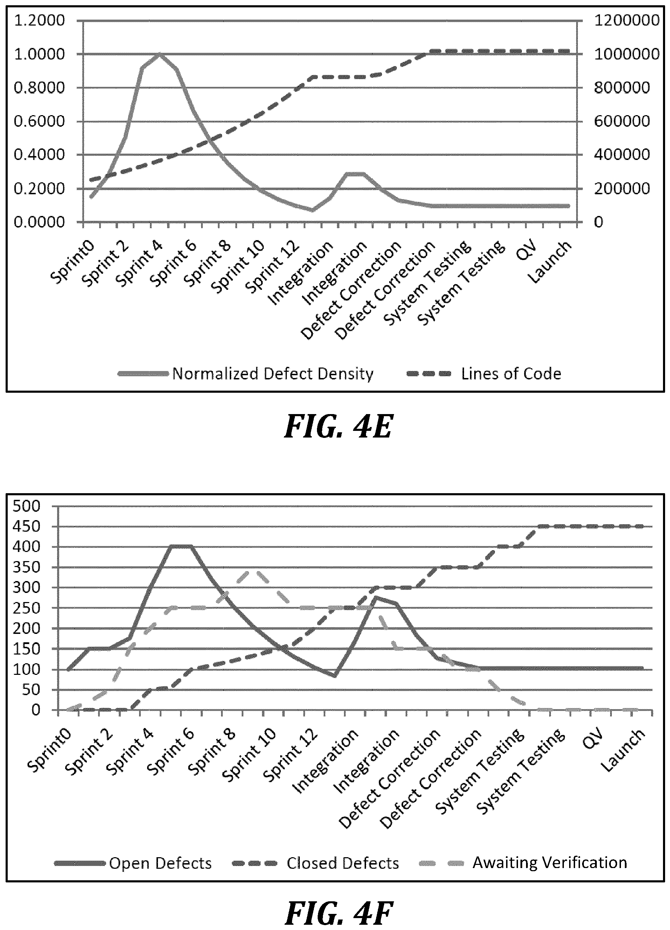

FIGURE 4E is a chart that illustrates a defect density metric useful according to various aspects of the present disclosure. The defect density may be measured as a percentage of open defects normalized by the total number of lines of code. For example, the defect density may be determined as a number of defects divided by a number of lines of code. The normalized defect density over time may then be determined by dividing the defect density by the maximum defect density over time. One purpose of defect density is to monitor the creation and correction of defects as related to the development cycle and increase in complexity over time. It is anticipated that, for a healthy development process, defects would be detected early in the program and be corrected.

FIGURE 4F is a chart that illustrates a defect tracking metric useful according to various aspects of the present disclosure. Defect tracking may record a total number of open defects, a total number of closed defects, and a total number of defects to be verified over the development cycle. One purpose of this metric is to measure the performance of the process to detect and correct defects early in the development process.

In some embodiments, the information collected by the quality improvement system 200, including the metrics described above, may be used to determine whether quality of a completed electronic component has been assured before final release to manufacturing. Such an analysis may include one or more of a requirements drawing that tracks all requirements related to the electronic component; a software design verification plan and report (DVP&R) that indicates that all validation levels have been satisfied and documented; results of unit testing; results of functional testing; results of user acceptance testing; a system failure mode and effects analysis (FMEA) that includes mechanical and electrical systems within the boundary of the design of the electronic component; a hazard assessment conducted per ISO 26262 (which may be included instead of the FMEA); a warrant of factory tool programming compliance; a warrant of field diagnostic tool compliance; a certified capability assessment; a notification of software implementation; the completed metrics described above; a design interface document showing all interfaces including but not limited to electrical, messaging, J1939 communications, software layer interfaces, digital and analog I/O, interrupts, and timing diagrams; an ASIL level for all safety-related content; and release notes.

The number of quality assurance factors listed above that are used may be determined by an estimation of impact. For example, for an existing electronic component and requirements changes of less than 5%, if the supplier has provided previous high-quality work then the quality assurance factors may be limited to the requirements drawing, the DVP&R, the warrants for factory tool programming compliance and field diagnostic tool compliance, the notification of software implementation, and release notes. For existing electronic components and requirements changes of between 5% and 30%, if the supplier has provided previous high-quality work then all of the factors may be used, but the system FMEA, the hazard assessment, the capabilities assessment, the final metrics, and the design interface document may be archived by the supplier instead of being submitted to or determined by the quality improvement system 200. For more complex projects or for projects from a new supplier, all of the quality assurance factors should be submitted to the quality improvement system 200 for verification.

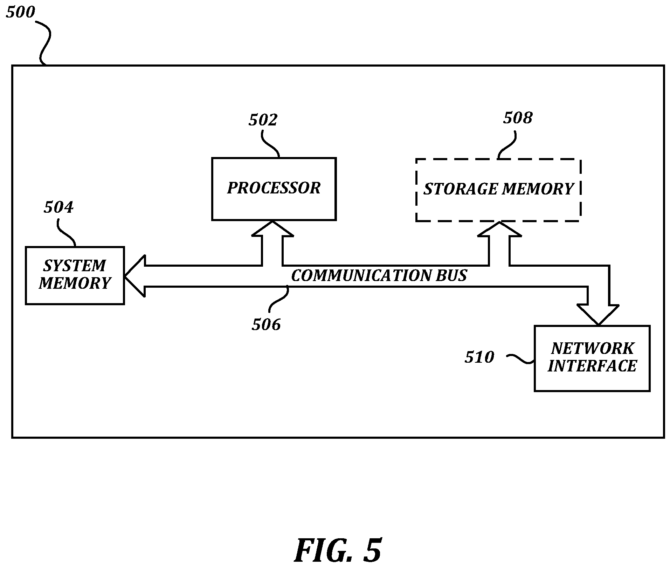

FIGURE 5 is a block diagram that illustrates aspects of an example computing device 500 appropriate for use as a computing device of the present disclosure. While multiple different types of computing devices were discussed above, the exemplary computing device 500 describes various elements that are common to many different types of computing devices. While FIGURE 5 is described with reference to a computing device that is implemented as a device on a network, the description below is applicable to servers, personal computers, mobile phones, smart phones, tablet computers, embedded computing devices, and other devices that may be used to implement portions of embodiments of the present disclosure. Moreover, those of ordinary skill in the art and others will recognize that the computing device 500 may be any one of any number of currently available or yet to be developed devices.

In its most basic configuration, the computing device 500 includes at least one processor 502 and a system memory 504 connected by a communication bus 506. Depending on the exact configuration and type of device, the system memory 504 may be volatile or nonvolatile memory, such as read only memory ("ROM"), random access memory ("RAM"), EEPROM, flash memory, or similar memory technology. Those of ordinary skill in the art and others will recognize that system memory 504 typically stores data and/or program modules that are immediately accessible to and/or currently being operated on by the processor 502. In this regard, the processor 502 may serve as a computational center of the computing device 500 by supporting the execution of instructions.

As further illustrated in FIGURE 5, the computing device 500 may include a network interface 510 comprising one or more components for communicating with other devices over a network. Embodiments of the present disclosure may access basic services that utilize the network interface 510 to perform communications using common network protocols. The network interface 510 may also include a wireless network interface configured to communicate via one or more wireless communication protocols, such as Wi-Fi, 2G, 3G, LTE, WiMAX, Bluetooth, Bluetooth low energy, and/or the like. As will be appreciated by one of ordinary skill in the art, the network interface 510 illustrated in FIGURE 5 may represent one or more wireless interfaces or physical communication interfaces described and illustrated above with respect to particular components of the system 100.

In the exemplary embodiment depicted in FIGURE 5, the computing device 500 also includes a storage medium 508. However, services may be accessed using a computing device that does not include means for persisting data to a local storage medium. Therefore, the storage medium 508 depicted in FIGURE 5 is represented with a dashed line to indicate that the storage medium 508 is optional. In any event, the storage medium 508 may be volatile or nonvolatile, removable or nonremovable, implemented using any technology capable of storing information such as, but not limited to, a hard drive, solid state drive, CD ROM, DVD, or other disk storage, magnetic cassettes, magnetic tape, magnetic disk storage, and/or the like.

As used herein, the term "computer-readable medium" includes volatile and non-volatile and removable and non-removable media implemented in any method or technology capable of storing information, such as computer readable instructions, data structures, program modules, or other data. In this regard, the system memory 504 and storage medium 508 depicted in FIGURE 5 are merely examples of computer-readable media.

Suitable implementations of computing devices that include a processor 502, system memory 504, communication bus 506, storage medium 508, and network interface 510 are known and commercially available. For ease of illustration and because it is not important for an understanding of the claimed subject matter, FIGURE 5 does not show some of the typical components of many computing devices. In this regard, the computing device 500 may include input devices, such as a keyboard, keypad, mouse, microphone, touch input device, touch screen, tablet, and/or the like. Such input devices may be coupled to the computing device 500 by wired or wireless connections including RF, infrared, serial, parallel, Bluetooth, Bluetooth low energy, USB, or other suitable connections protocols using wireless or physical connections. Similarly, the computing device 500 may also include output devices such as a display, speakers, printer, etc. Since these devices are well known in the art, they are not illustrated or described further herein.

While illustrative embodiments have been illustrated and described, it will be appreciated that various changes can be made therein without departing from the spirit and scope of the invention.

## Claims

1. A vehicle, comprising:
one or more electronically controlled components;
at least one electronic control unit (ECU) configured to control an action of at least one of the one or more electronically controlled components, wherein the ECU is configured and installed in the vehicle by:
selecting a supplier based on a need of a manufacturing process of the ECU;
receiving data from the supplier during a design process and using the data to monitor the supplier;
testing a completed ECU provided by the supplier; and
installing the tested ECU in the vehicle.

2. The vehicle of Claim 1, wherein the one or more electronically controlled components include at least one of an engine, an operator display, a transmission, a throttle, a brake, and a pump.

3. The vehicle of any one of Claims 1-2, wherein selecting a supplier includes gathering information about suppliers to form a basis of the selection.

4. The vehicle of any one of Claims 1-3, wherein receiving data from the supplier during the design process and using the data to monitor the supplier includes:
receiving data regarding progress of a software design process; and
analyzing the data using one or more metrics.

5. The vehicle of Claim 4, wherein the one or more metrics include measuring at least one of code growth, requirements coverage, requirements change management, test coverage, defect density, and defect tracking.

6. The vehicle of any one of Claims 1-5, wherein testing includes at least one of software-in-loop (SIL) testing and hardware-in-loop (HIL) testing.

7. The vehicle of any one of Claims 1-6, wherein the vehicle is a Class 8 truck.

8. A method of manufacturing a vehicle that includes an electronic component, the method comprising:
selecting a supplier based on a need of a manufacturing process of the electronic component;
receiving data from the supplier during a design process and using the data to monitor the supplier;
testing a completed electronic component provided by the supplier; and
installing the tested electronic component in the vehicle.

9. The method of Claim 8, wherein the electronic component is an engine controller, an operator display controller, a transmission controller, a throttle controller, a brake controller, or a pump controller.

10. The method of any one of Claims 8-9, wherein selecting a supplier includes gathering information about suppliers to form a basis of the selection.

11. The method of any one of Claims 8-10, wherein receiving data from the supplier during the design process and using the data to monitor the supplier includes:
receiving data regarding progress of a software design process; and
analyzing the data using one or more metrics.

12. The method of Claim 11, wherein the one or more metrics include measuring at least one of code growth, requirements coverage, requirements change management, test coverage, defect density, and defect tracking.

13. The method of any one of Claims 8-12, wherein testing includes at least one of software-in-loop (SIL) testing and hardware-in-loop (HIL) testing.

14. The method of any one of Claims 8-13, wherein the vehicle is a Class 8 truck.

15. A computing system for improving the quality of production of an electronic component for a vehicle, the system comprising:
a supplier interface module;
a supplier intake questionnaire data store configured to store responses from suppliers received by the supplier interface module;
a supplier compliance data store configured to store data received by the supplier interface module from suppliers during a design process of the electronic component; [[and]]
a test data store configured to store test data for the electronic component; and
a quality improvement module configured to analyze data from the supplier compliance data store using one or more metrics, wherein the one or more metrics include measuring at least one of code growth, requirements coverage, requirements change management, test coverage, defect density, and defect tracking.
